# EUROPÄISCHE PATENTSCHRIFT

(11) **EP 2 770 637 B1**
(45) Veröffentlichungstag und Bekanntmachung des Hinweises auf die Patenterteilung: **19.08.2015**
(21) Anmeldenummer: 13156405.6
(22) Anmeldetag: 22.02.2013
(51) Int. Cl.: H03K 17/605, H03K 19/003, G05B 19/05

(54) **Optokoppleranordnung und Ein- und/oder Ausgabebaugruppe**
Optical coupler assembly and input and/or output component
Agencement d'optocoupleur et groupe d'entrée et/ou sortie

(43) Veröffentlichungstag der Anmeldung: 27.08.2014
(73) Patentinhaber: Siemens Aktiengesellschaft, 80333 München (DE)
(72) Erfinder: Holtz, Stefan, 09112 Chemnitz (DE)

(56) Entgegenhaltungen:
- EP-A2- 2 506 436
- GB-A- 2 241 126
- US-A- 5 909 660

## Beschreibung

Die Erfindung betrifft eine Optokoppleranordnung zur Signalübertrag bei galvanischer Trennung. Auch betrifft die Erfindung eine Ein- und/oder Ausgabebaugruppe der industriellen Automatisierungstechnik mit Ein- und/oder Ausgabekanälen, wobei die Kanäle die Optokoppleranordnung aufweisen.

Ein Optokoppler ist ein elektronisches Bauelement und dient zur Übertragung eines Signals zwischen zwei galvanisch getrennten Stromkreisen. Vorzugsweise umfasst ein Optokoppler einen optischen Sensor, beispielsweise eine Leuchtdiode, und einen optischen Empfänger, beispielsweise einen Fototransistor, welche vorzugsweise in einem lichtundurchlässigen Gehäuse untergebracht sind.

Aus der EP 1 770 457 B1 und US 5,909,660 ist eine Optokoppleranordnung zur galvanischen Trennung von Signalen bekannt. Auch wird in der EP 1 770 457 B1 eine Peripheriebaugruppe, beispielsweise eine Ein- oder Ausgabebaugruppe, für ein Automatisierungsgerät, welche diese Optokoppleranordnung aufweist, beschrieben.

In elektronischen Baugruppen, in denen zur galvanischen Trennung von Signalen Optokoppler eingesetzt werden, erhöht sich eine Verlustleistung, welche auf die Ansteuerung der Optokoppler bezogen wird, linear mit der Anzahl der anzusteuernden Optokoppler.

Um diese Verlustleistung zu minimieren, wurden bisher z.B. Magnetkoppler und/oder kapazitive Koppler eingesetzt, diese haben allerdings den Nachteil, dass sie in der Regel kostenintensiver als Optokoppler sind und zusätzliche Schaltungen zur Versorgung der Sekundärseite benötigen.

Bezogen auf die Prozessautomatisierung können in Industrieanlagen durchaus 10.000 zu steuernde bzw. zu erfassende Ein-/Ausgänge vorkommen. Diese hohe Anzahl von Ein-/Ausgängen muss zur Erfassung auf Ein-/Ausgabebaugruppen aufgeteilt werden. Diese Ein-/Ausgabebaugruppen sind dazu in der Regel mehrkanalig, mit jeweils einen Optokoppler pro Kanal ausgestaltet.

Es ist Aufgabe der vorliegenden Erfindung eine Optokoppleranordnung bzw. eine Ein-/Ausgabebaugruppe bereitzustellen, bei welcher die durch die Optokoppler hervorgerufene Verlustleistung reduziert werden kann.

Die Aufgabe wird durch eine Optokoppleranordnung gemäß den Merkmalen des Anspruchs 1 gelöst. Die Optokoppleranordnung zur Signalübertragung bei galvanischer Trennung umfasst einen ersten Optokoppler mit einem ersten Eingangspfad und einem ersten Ausgangspfad, einen zweiten Optokoppler mit einem zweiten Eingangspfad und einem zweiten Ausgangspfad, einem ersten Signaleingang, einem zweiten Signaleingang, wobei der erste Eingangspfad und der zweite Eingangspfad derart mit einem Verbindungsschaltmittel in einer Reihenschaltung angeordnet ist, dass das Verbindungsschaltmittel den ersten Eingangspfad mit dem zweiten Eingangspfad verbindet, wobei eine Ansteuerschaltung als Eingänge den ersten Signaleingang und den zweiten Signaleingang, und als Ausgänge einen ersten Ausgang, einen zweiten Ausgang und einen dritten Ausgang aufweist, die Ansteuerschaltung ist dabei derart ausgestaltet, dass in Abhängigkeit von einem auf den ersten und zweiten Signaleingang bezogenen ersten Schaltzustand, dass Verbindungsschaltmittel angesteuert wird, und bezogen auf einen zweiten Schaltzustand bzw. einen dritten Schaltzustand ein erstes Schaltmittel, welches dem ersten Eingangspfad des ersten Optokopplers zugeordnet ist bzw. ein zweites Schaltmittel, welches den zweiten Eingangspfad des zweiten Optokopplers zugeordnet ist, angesteuert wird. Bei dieser Anordnung ist mit dem Vorteil der Energieeinsparung eine Optokoppleranordnung realisiert, bei welcher ein Schaltzustand abhängiges Hintereinanderschalten des ersten und des zweiten Optokopplers durchgeführt wird. Optokoppler verwenden in der Regel Infrarotdioden zur Ansteuerung von beispielsweise Fototransistoren. Diese Art der Infrarotleuchtdioden haben eine recht geringe Flussspannung von maximal 1,2 Volt. Bei der Flussspannung von 1,2 Volt können beispielsweise bei einer Systemspannung von beispielsweise 3,3 Volt zwei Optokoppler hintereinandergeschaltet werden. Dadurch fällt bei der Ansteuerung von zwei hintereinandergeschalteten Optokopplern die gleiche Verlustleistung an wie bei der Ansteuerung von einem Optokoppler. Für den Fall, dass die zwei Signaleingänge der Optokoppleranordnung gleichzeitig angesteuert werden, also auch beide Optokoppler ein Signal ausgeben müssen, werden diese beiden Optokoppler im Falle der gleichzeitigen Ansteuerung schaltungstechnisch hintereinandergeschaltet. Die dafür benötigten Komponenten sind vorzugsweise eine Stromquelle, die unabhängig von der Eingangsspannung den benötigten Infrarotleuchtdioden-Strom liefert, logische Gatter, wie beispielsweise ein NAND-Gatter, und beispielsweise Bipolartransistoren.

In einer bevorzugten Weiterbildung erhält man eine Optokoppleranordnung mit einer Stromquelle, welche an einer ersten Seite des ersten Eingangspfad angeschlossen ist, wobei eine zweite Seite des ersten Eingangspfads an einen ersten Anschluss des Verbindungsschaltmittels und eine erste Seite des zweiten Eingangspfad an einen zweiten Anschluss des Verbindungsschaltmittels angeschlossen ist und eine zweite Seite des zweiten Eingangspfads an einem Punkt angeschlossen ist, welcher einen Stromfluss von der Stromquelle über den ersten Eingangspfad, das Verbindungsschaltmittel, dem zweiten Eingangspfad zurück zur Stromquelle ermöglicht. Der Punkt kann als ein Masse-Bezugspotential angesehen werden. Der beschriebene Stromweg beschreibt nun den Fall, dass beide Optokoppler gleichzeitig aktiviert sind. Diese schaltzustandsabhängige Hintereinanderschaltung der Optokoppler wird in der Ansteuerschaltung dadurch realisiert, dass wenn der erste Signaleingang "1" führend ist und der zweite Signaleingang ebenfalls "1" führend ist, wird das Verbindungsschaltmittel derart angesteuert, dass von der Stromquelle durch beide Optokoppler der gleiche Strom fließen kann und somit im Gegensatz zu Optokoppleranordnungen nach dem Stand der Technik nicht jeder Optokoppler mit einem eigenen Strom versorgt werden muss.

In einer weiteren Ausgestaltung ist an der zweiten Seite das erste Schaltmittel mit einem ersten Anschluss angeschlossen und ein zweiter Anschluss des ersten Schaltmittels ist an dem Punkt M angeschlossen. Da das erste Schaltmittel dem ersten Optokoppler zugeordnet ist und dafür sorgen soll, dass ein Stromfluss durch den ersten Eingangspfad bei entsprechender Ansteuerung entsteht, ist die Ansteuerschaltung mit dem ersten Schaltmittel dazu ausgestaltet, für den Fall das nur der erste Signaleingang "1" führend ist, das erste Schaltmittel anzusteuern, so dass von der Stromquelle über den ersten Eingangspfad des ersten Kopplers ein Strom fließen kann, welcher über das erste Schaltmittel zurück zu einen Massebezugspunkt fließt, so dass der erste Optokoppler aktiviert ist.

Um auch den zweiten Optokoppler einzeln zu aktivieren, ist an der ersten Seite des zweiten Eingangspfads das zweite Schaltmittel mit einem ersten Anschluss angeschlossen und ein zweiter Anschluss des zweiten Schaltmittels ist an der Stromquelle angeschlossen. Für den Fall, dass nur der zweite Signaleingang "1" führend ist, kann von der Stromquelle über das zweite Schaltmittel ein Strom über den zweiten Eingangspfad zu einen Massebezugspotential fließen, so dass der zweite Optokoppler einzeln aktiviert werden kann.

In einer bevorzugten Ausgestaltung und um eine Möglichkeit dafür zu haben die Schaltmittel entsprechend anzusteuern, ist der ersten Ausgang an einem dritten Anschluss des ersten Schaltmittels, der zweite Ausgang an einem dritten Anschluss des zweiten Schaltmittels und der dritte Ausgang an einem dritten Anschluss des Verbindungsschaltmittels angeschlossen.

Bei der Optokoppleranordnung ist die Ansteuerschaltung zur logischen Verknüpfung des ersten Signaleingangs und des zweiten Signaleingangs derart ausgestaltet, dass bei einem Signal am ersten Signaleingang der erste Optokoppler aktiviert wird und bei einem Signal am zweiten Signaleingang der zweite Optokoppler aktiviert wird und bei je einem Signal am ersten und am zweiten Signaleingang der erste und der zweite Optokoppler zur Stromeinsparung in einer Reihenschaltung aktiviert werden.

Die eingangs genannte Aufgabe wird ebenfalls durch eine Ein- und/oder Ausgabebaugruppe der industriellen Automatisierungstechnik mit mindestens vier Kanälen, wobei ein erster Kanal und ein zweiter Kanal mit einer ersten Optokoppleranordnung nach einem der Ansprüche 1 bis 5 ausgestaltet sind, und ein dritter Kanal und ein vierter Kanal mit einer zweiten Optokoppleranordnung nach einem der Ansprüche 1 bis 5 ausgestaltet sind, gelöst.

In einem System, in den die Optokoppleranordnung eingesetzt wird, z.B. einem modularen Steuerungssystem mit Ein-/Ausgabebaugruppen, hilft die Energieeinsparung Systemvorgaben, z.B. bezüglich eines maximal möglichen Systemausbaus, bedingt durch die Gesamtverlustleistung, einzuhalten.

In einer Automatisierungskomponente in dem die Optokoppleranordnung eingesetzt wird hilft diese, beispielsweise eine Abwärmeentwicklung zu reduzieren, was die in der Automatisierungskomponente verwendeten elektrischen Bauteile thermisch entlastet und damit ihre Lebensdauer erhöht. Ebenfalls wird Versorgungsenergie gespart, welches die Betriebskosten senkt und auch die Möglichkeit kleinere Netzteile einzusetzen hervorbringt, welches wiederum die Systemkosten verringert.

Wird die Optokoppleranordnung in einem Schaltschrank eingesetzt, hilft die verringerte Wärmeentwicklung einem Anlagenbauer Kosten und Energie bei einer Kühlung des Schaltschrankes einzusparen.

Die Zeichnung zeigt ein Ausführungsbeispiel. Es zeigt
- FIG 1: eine Optokoppleranordnung,
- FIG 2: eine Zustandstabelle für die Schaltzustände der Signaleingänge und
- FIG 3: eine Automatisierungskomponente, insbesondere eine Ein-/Ausgabebaugruppe, mit zwei Optokoppleranordnungen.

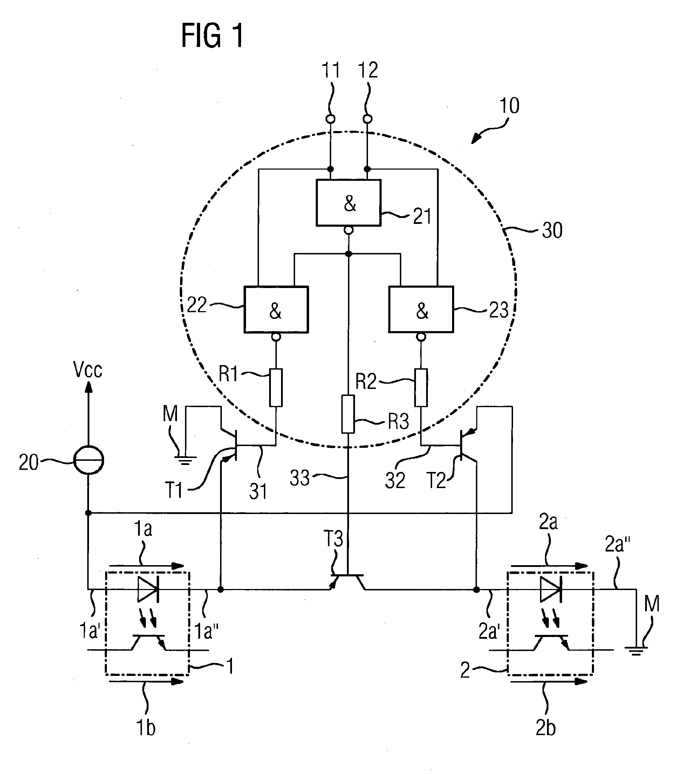

Gemäß FIG 1 ist eine Optokoppleranordnung 10 zur Signalübertragung bei galvanischer Trennung dargestellt. Signale, welche über einen ersten Signaleingang 11 und einen zweiten Signaleingang 12 anliegen können, sollen durch einen ersten Optokoppler 1 und einen zweiten Optokoppler 2 galvanisch getrennt weitergegeben werden. Dazu weist der erste Optokoppler 1 einen ersten Eingangspfad 1a und einen ersten Ausgangspfad 1b und der zweite Optokoppler 2 einen zweiten Eingangspfad 2a und einen zweiten Ausgangspfad 2b auf.

Wird der erste Eingangspfad 1a stromdurchflossen, so wird der erste Optokoppler 1 aktiviert und im ersten Ausgangspfad 1b kann ebenfalls ein Stromfluss erfolgen, wird der zweite Eingangspfad 2a des zweiten Optokopplers 2 stromdurchflossen, so wird der zweite Optokoppler 2 aktiviert und im zweiten Ausgangspfad 2b kann ebenfalls ein Strom fließen.

Der erste Eingangspfad 1a und der zweite Eingangspfad 2a sind mit einem Verbindungsschaltmittel T3 in einer Reihenschaltung angeordnet, dass Verbindungsschaltmittel T3 verbindet den ersten Eingangspfad 1a mit dem zweiten Eingangspfad 2a.

Eine Ansteuerschaltung 30 weist als Eingänge den ersten Signaleingang 11 und den zweiten Signaleingang 12, und als Ausgänge einen ersten Ausgang 31, einen zweiten Ausgang 32 und einen dritten Ausgang 33 auf.

Die Ansteuerschaltung 30 ist dabei mit einem ersten Und-Glied 21, einem zweiten Und-Glied 22 und einem dritten Und-Glied 23 ausgestaltet. Die jeweiligen Ausgänge der Und-Glieder 21,22, 23 sind negierend ausgestaltet.

Demnach ist die Ansteuerschaltung 30 derart ausgestaltet, dass in Abhängigkeit von einem auf den ersten und zweiten Signaleingang 11,12 bezogenen ersten Schaltzustand S1, dass Verbindungsschaltmittel T3 angesteuert wird, und bezogen auf einen zweiten Schaltzustand S2 bzw. einem dritten Schaltzustand S3 ein erstes Schaltmittel T1, welches dem ersten Eingangspfad 1a des ersten Optokopplers 1 zugeordnet ist bzw. ein zweites Schaltmittel T2, welches dem zweiten Eingangspfad 2a des zweiten Optokopplers 2 zugeordnet ist, angesteuert wird.

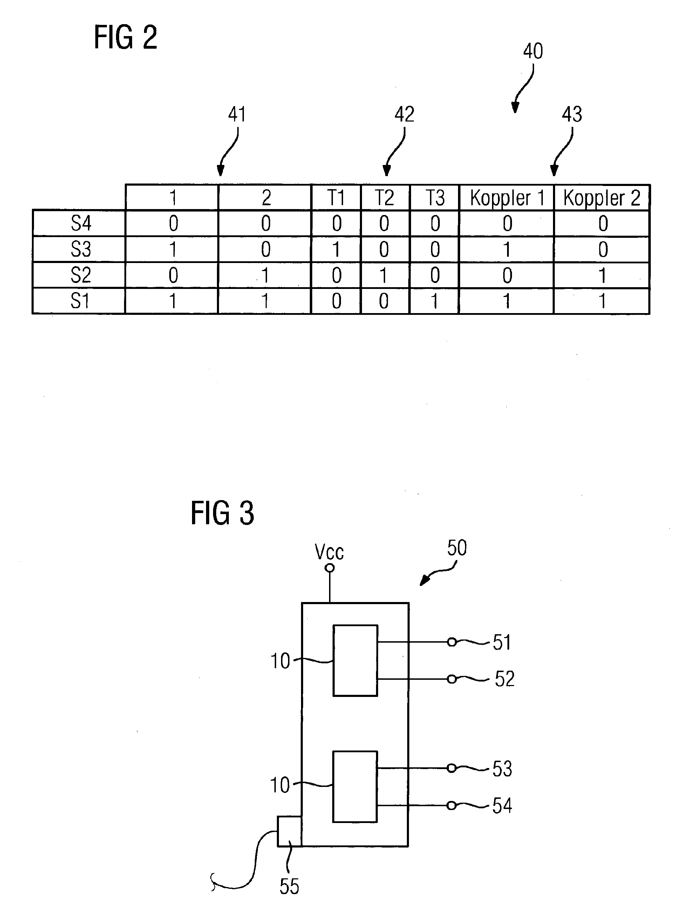

FIG 2 zeigt eine Zustandstabelle 40, bei welcher in der ersten Spalte die Schaltzustände S1,...,S4 aufgeführt sind. Der Zustand der Signaleingänge 41 ist mit "0" "1". Der Zustand 42 der unterschiedlichen Schaltmittel T1,T2,T3 ist ebenfalls mit "0" oder "1" abgebildet. Der Zustand 43 der einzelnen Optokoppler ist ebenfalls mit "0" und "1" abgebildet.

Der erste Schaltzustand S1, bei dem der erste Signaleingang 11 und der zweite Signaleingang 12 signalführend sind, wird unter Bezugnahme der FIG 1 erklärt. An dem ersten Signaleingang 11 und dem zweiten Signaleingang 12 liegt jeweils ein "1" Signal. Da das erste Und-Glied 21 als ein NAND-Gatter ausgestaltet ist, liegt an einem der Eingänge des zweiten Und-Gliedes 22 eine "0". Der andere Eingang des zweiten Und-Gliedes 22 weist eine "1", da der erste Signaleingang 11 zu dem anderen Eingang des zweiten Und-Gliedes 22 durch verbunden wurde. Da auch das zweite Und-Glied 22 als ein NAND-Gatter ausgestaltet ist, weist sein Ausgang nun eine "1" auf. Dieses "1" Signal wird über einen ersten Vorwiderstand R1 als der erste Ausgang 31 an das erste Schaltmittel T1 angelegt.

Da die Schaltmittel T1,T2,T3 als PNP-Transistoren ausgestaltet sind, erfolgt die Ansteuerung mit Spannungspegel "0" an der Basis. Da aber wie zuvor beschrieben, ein "1" Signal an der Basis des ersten Schaltmittels T1 anliegt, wird das erste Schaltmittel T1 nicht angesteuert.

Eine analoge technische Verschaltung gilt für den Zweig des zweiten Signaleingangs 12 bis hin zu den zweiten Schaltmittel T2, auch hier wird das zweite Schaltmittel T2 nicht angesteuert.

Für den Fall, dass beide Signaleingänge 11,12 "1" führend sind, sperren das erste Schaltmittel T1 und das zweite Schaltmittel T2. Aber das Verbindungsschaltmittel T3 wird derart angesteuert, dass es leitend ist. Von der Stromquelle 20 kann bedingt durch einen Versorgungsspannungsanschluss Vcc ein Strom über den ersten Eingangspfad 1a, über das dritte Schaltmittel T3, über den zweiten Eingangspfad 2a zu einem Punkt M fließen. Der Stromfluss durch die beiden Optokoppler 1,2 aktiviert den ersten Optokoppler 1 und den zweiten Optokoppler 2 gleichzeitig. Bei dem ersten Schaltzustand S1 wird demnach über die schaltzustandsabhängige Hintereinanderschaltung des ersten Optokopplers 1 und des zweiten Optokopplers 2 Energie eingespart.

Gemäß FIG 3 ist eine Ein- und/oder Ausgabebaugruppe 50 der industriellen Automatisierungstechnik mit mindestens vier Kanälen 51,52,53,54, wobei ein erster Kanal 51 und ein zweiter Kanal 52 mit einer ersten Optokoppleranordnung 10 und ein dritter Kanal 53 und ein vierter Kanal 54 mit einer zweiten Optokoppleranordnung 10 ausgestaltet ist, dargestellt. Für eine Versorgung mit einer Spannung weist die Ein- und/oder Ausgabebaugruppe 50 einen Versorgungsspannungsanschluss Vcc auf. Zur Kommunikation mit einem übergeordneten Automatisierungsgerät hat die Ein- und/oder Ausgabebaugruppe 50 einen Busanschluss 55.

Ein Automatisierungssystem umfassend ein Kommunikationsmodul, welches eine Verbindung zwischen einer zentralen Steuerung und den eigentlichen Ein- und/oder Ausgabebaugruppen, wie z.B. dezentrale Peripheriebaugruppen, herstellt, wird demnach bei einem großen industriellen Prozess eine Vielzahl von Ein- und/oder Ausgabebaugruppen, welche an einem Kommunikationsmodul angeschlossen sind, aufweisen. Da in der Regel die Energieversorgung der dezentralen Peripheriebaugruppen also der Ein- und/oder Ausgabebaugruppen durch das Kommunikationsmodul übernommen wird, ist die Anzahl der an einem Kommunikationsmodul betreibbaren Ein- Ausgabebaugruppen von der Leistung eines dem Kommunikationsmodul zugeordneten Netzteils abhängig. Um die Systemvorgaben bezüglich der Anzahl der betreibbaren Ein-/Ausgabebaugruppen einhalten zu können, ist jede Ein-/Ausgabebaugruppe auf eine maximale Stromaufnahme beschränkt.

In einem Beispielfall ist die Stromaufnahme eines funktionalen Teils der Ein-/Ausgabebaugruppe auf 8 mA beschränkt. Eine zu entwickelnde Baugruppe soll vier Triacs optisch getrennt ansteuern und dafür nicht mehr als 8 mA aufwenden. Optisch getrennte Triacs haben funktionsbedingt einen recht hohen Strombedarf von 4 mA. Werden diese 4 Triacs jetzt auf herkömmliche Weise parallel angesteuert, ergibt sich bei Ansteuerung aller vier Kanäle gleichzeitig ein Stromdbedarf von 16 mA. Dieser Strombedarf überschreitet den maximal zulässigen Wert und damit die Systemvorgabe bezüglich eines maximalen Systemaufbaus. Somit wäre es für dieses Automatisierungssystem nicht möglich, eine Ein-/Ausgabebaugruppe zu bauen, welche vier Triac-Kanäle enthält und diese gleichzeitig ansteuern kann.

Um eine Ein-/Ausgabebaugruppe zu realisieren, welches die maximalen Stromvorgaben aufweist, braucht es eine stromsparende Ansteuerschaltung für die Triacs. Der zur Ansteuerung eines Triacs benötigte Strom lässt sich aufgrund von physikalischen Beschränkungen nicht unter eine 4 mA Grenze absenken. Um die Systemvorgaben doch einhalten zu können, kommt die Optokoppleranordnung 10 zum Einsatz. Dabei beträgt eine verwendete Systemspannung beispielsweise 3,5 V und ein Spannungsabfall über den ersten Optokoppler 1 und den zweiten Optokoppler 2 maximal je 1,1 V.

Abhängig von den logischen Zuständen des ersten Signaleingangs 11 und des zweiten Signaleingangs 12 werden die Schaltmittel T1,T2 und T3, beispielsweise Transistoren, angesteuert. Die Verschaltung der Schaltmittel T1,T2 und T3 sorgen dafür, dass der erste Optokoppler 1 und der zweite Optokoppler 2 entweder einzeln oder hintereinander mit 4 mA versorgt und damit durchgesteuert werden.

Dank dieser Schaltung wird ein Ansteuerstrom für zwei Kanäle, unabhängig vom Schaltzustand auf insgesamt maximal 4 mA begrenzt. Mit der dadurch auf maximal 8 mA für vier Kanäle begrenzten Stromaufnahme ist es möglich, eine vierkanalige Triac-Baugruppe zu bauen, die die Systemvorgaben einhält.

## Patentansprüche

1. Optokoppleranordnung (10) zur Signalübertragung bei galvanischer Trennung, umfassend einen
• ersten Optokoppler (1) mit einem ersten Eingangspfad (1a) und einem ersten Ausganspfad (1b), einen
• zweiten Optokoppler (2) mit einem zweiten Eingangspfad (2a) und einem zweiten Ausgangspfad (2b), einen
• ersten Signaleingang (11), einen
• zweiten Signaleingang (12),
wobei der erste Eingangspfad (1a) und der zweite Eingangspfad (2a) derart mit einem Verbindungsschaltmittel (T3) in einer Reihenschaltung angeordnet ist, dass das Verbindungsschaltmittel (T3) den ersten Eingangspfad (1a) mit dem zweiten Eingangspfad (2a) verbindet,
wobei eine Ansteuerschaltung (30) als Eingänge den ersten Signaleingang (11) und den zweiten Signaleingang (12), und als Ausgänge einen ersten Ausgang (31), einen zweiten Ausgang (32) und einen dritten Ausgang (33) aufweist,
die Ansteuerschaltung (30) ist dabei derart ausgestaltet, dass in Abhängigkeit von einem auf den ersten und zweiten Signaleingang (11,12) bezogenen ersten Schaltzustand (S1), das Verbindungsschaltmittel (T3) angesteuert wird, und bezogen auf einen zweiten Schaltzustand (S2) bzw. einen dritten Schaltzustand (S3) ein erstes Schaltmittel (T1), welches dem ersten Eingangspfad (1a) des ersten Optokopplers (1) zugeordnet ist bzw. ein zweites Schaltmittel (T2), welches dem zweiten Eingangspfad (2a) des zweiten Optokopplers (2) zugeordnet ist, angesteuert wird.

2. Optokoppleranordnung (10) nach Anspruch 1, mit einer Stromquelle (20), welche an einer ersten Seite (1a') des ersten Eingangspfads (1a) angeschlossen ist, wobei eine zweite Seite (1a") des ersten Eingangspfads (1a) an einen ersten Anschluss des Verbindungsschaltmittels (T3) und eine erste Seite (2a') des zweiten Eingangspfads (2a) an einen zweiten Anschluss des Verbindungsschaltmittels (T3) angeschlossen ist und eine zweite Seite (2a") des zweiten Eingangspfads (2a) an einen Punkt (M) angeschlossen ist, welcher einen Stromfluss von der Stromquelle (20) über den ersten Eingangspfad (1a), das Verbindungsschaltmittel (T3), dem zweiten Eingangspfad (2a) zurück zur Stromquelle (20) ermöglicht.

3. Optokoppleranordnung (10) nach Anspruch 2, wobei an der zweiten Seite (1a") des ersten Eingangspfads (1a) das erste Schaltmittel (T1) mit einem ersten Anschluss angeschlossen ist und ein zweiter Anschluss des ersten Schaltmittels (T1) an dem Punkt (M) angeschlossen ist.

4. Optokoppleranordnung (10) nach Anspruch 3, wobei an der ersten Seite (2a') des zweiten Eingangspads (2a) das zweite Schaltmittel (T2) mit einem ersten Anschluss angeschlossen ist und ein zweiter Anschluss des zweiten Schaltmittels (T2) an der Stromquelle (20) angeschlossen ist.

5. Optokoppleranordnung (10) nach einem der Ansprüche 1 bis 4, wobei der erste Ausgang (31) an einem dritten Anschluss des ersten Schaltmittels (T1), der zweite Ausgang (32) an einem dritten Anschluss des zweiten Schaltmittels (T2) und der dritte Ausgang (33) an einem dritten Anschluss des Verbindungsschaltmittels (T3) angeschlossen sind.

6. Optokoppleranordnung (10) nach einem der Ansprüche 1 bis 5, wobei die Ansteuerschaltung (30) zur logischen Verknüpfung des ersten Signaleingangs (11) und des zweiten Signaleingangs (12) derart ausgestaltet ist, dass bei einem Signal am ersten Signaleingang (11) der erste Optokoppler (1) aktiviert wird und bei einem Signal am zweiten Signaleingang (12) der zweite Optoloppler (2) aktiviert wird und bei je einem Signal am ersten und am zweiten Signaleingang (11,12) der erste und zweite Optokoppler (1,2) zur Stromeinsparung in einer Reihenschaltung aktiviert werden.

7. Ein- und oder Ausgabebaugruppe (50) der industriellen Automatisierungstechnik mit mindestens vier Kanälen (51,52,53, 54), wobei ein erster Kanal (51) und ein zweiter Kanal (52) mit einer ersten Optokoppleranordnung (10) nach einem der Ansprüche 1 bis 5 ausgestaltet sind,
und ein dritter Kanal (53) und ein vierter Kanal (54) mit einer zweiten Optokoppleranordnung (10) nach einem der Ansprüche 1 bis 5 ausgestaltet sind.

## Claims

1. Optocoupler arrangement (10) for signal transmission with galvanic separation, including a
• first optocoupler (1) with a first input path (1a) and a first output path (1b), a
• second optocoupler (2) with a second input path (2a) and a second output path (2b), a
• first signal input (11), a
• second signal input (12),
wherein the first input path (1a) and the second input path (2a) are arranged in a series circuit with a connecting switching means (T3) such that the connecting switching means (T3) connects the first input path (1a) to the second input path (2a),
wherein an actuation circuit (30) has, as inputs, the first signal input (11) and the second signal input (12), and as outputs a first output (31), a second output (32) and a third output (33),
the actuation circuit (30) is configured here such that, as a function of a first switching state (S1) related to the first and second signal input (11,12), the connecting switching means (T3) is actuated, and with respect to a second switching state (S2) or a third switching state (S3), a first switching means (T1), which is assigned to the first input path (1a) of the first optocoupler (1) or a second switching means (T2), which is assigned to the second input path (2a) of the second optocoupler (2), is actuated.

2. Optocoupler arrangement (10) according to claim 1, having a current source (20), which is connected to a first side (1a') of the first input path (1a), wherein a second side (1a") of the first input path (1a) is connected to a first connection of the connecting switching means (T3) and a first side (2a') of the second input path (2a) is connected to a second connection of the connecting switching means (T3) and a second side (2a") of the second input path (2a) is connected to a point (M), which allows for current to flow from the current source (20) via the first input path (1a), the connecting switching means (T3), to the second input path (2a) and back to the current source (20).

3. Optocoupler arrangement (10) according to claim 2, wherein the first switching means (T1) with a first connection is connected to the second side (1a") of the first input path (1a) and a second connection of the first switching means (T1) is connected to the point (M).

4. Optocoupler arrangement (10) according to claim 3, wherein the second switching means (T1) with a first connection is connected to the first side (2a') of the second input path (2a) and a second connection of the second switching means (T2) is connected to the current source (20).

5. Optocoupler arrangement (10) according to one of claims 1 to 4, wherein the first output (31) is connected to a third connection of the first switching means (T1), the second output (32) to a third connection of the second switching means (T2) and the third output (33) to a third connection of the connecting switching means (T3).

6. Optocoupler arrangement (10) according to one of claims 1 to 5, wherein the actuation circuit (30) for logically linking the first signal input (11) and the second signal input (12) is configured such that with a signal at the first signal input (11), the first optocoupler (1) is activated, and with a signal at the second signal input (12), the second optocoupler (2) is activated, and with each signal at the first and at the second signal input (11,12), the first and the second optocoupler (1,2) are activated in order to save energy in a series circuit.

7. Input and or output module (50) within industrial automation technology having at least four channels (51, 52, 53, 54), wherein a first channel (51) and a second channel (52) are configured with a first optocoupler arrangement (10) according to one of claims 1 to 5,
and a third channel (53) and a fourth channel (54) with a second optocoupler arrangement (10) according to one of claims 1 to 5.

## Revendications

1. Agencement ( 10 ) d'optocoupleur pour transmettre un signal avec séparation galvanique, comprenant
• un premier optocoupleur ( 1 ) ayant un premier trajet ( 1a ) d'entrée et un premier trajet ( 1b ) de sortie,
• un deuxième optocoupleur ( 2 ) ayant un deuxième trajet ( 2a ) d'entrée et un deuxième trajet ( 2b ) de sortie,
• une première entrée ( 11 ) du signal,
• une deuxième entrée ( 12 ) du signal,
dans lequel le premier trajet ( 1a ) d'entrée et le deuxième trajet ( 2a ) d'entrée sont montés suivant un circuit série avec un moyen ( T3 ) de commutation de liaison, de manière à ce que le moyen ( T3 ) de commutation de liaison relie le premier trajet ( 1a ) d'entrée au deuxième trajet ( 2a ) d'entrée,
dans lequel un circuit ( 30 ) de commande a comme entrées la première entrée ( 11 ) du signal et la deuxième entrée ( 12 ) du signal et comme sorties une première sortie ( 31 ), une deuxième sortie ( 32 ) et une troisième sortie ( 33 ),
le circuit ( 30 ) de commande est conformé de manière à commander le moyen ( T3 ) de commutation de liaison en fonction d'un premier état ( S1 ) de commutation, rapporté à la première et à la deuxième entrées ( 11, 12 ) du signal, et à commander, rapporté à un deuxième état ( S2 ) de commutation ou à un troisième état ( S3 ) de commutation, un premier moyen ( T1 ) de commutation, qui est associé au premier trajet ( 1a ) d'entrée du premier optocoupleur ( 1 ), ou un deuxième moyen ( T2 ) de commutation, qui est associé au deuxième trajet ( 2a ) d'entrée du deuxième optocoupleur ( 2 ).

2. Agencement ( 10 ) d'optocoupleur suivant la revendication 1, comprenant une source ( 20 ) de courant, qui est reliée à un premier côté ( 1a' ) du premier trajet ( 1a ) d'entrée, un deuxième côté ( 1a" ) du premier trajet ( 1a ) d'entrée étant relié à une première borne du moyen ( T3 ) de commutation de liaison et un premier côté ( 2a' ) du deuxième trajet ( 2a ) d'entrée à une deuxième borne du moyen ( T3 ) de commutation de liaison et un deuxième côté ( 2a" ) du deuxième trajet ( 2a ) d'entrée est relié à un point ( M ), qui rend possible un flux de courant de la source ( 20 ) de courant par l'intermédiaire du premier trajet ( 1a ) d'entrée, du moyen ( T3 ) de commutation de liaison, au deuxième trajet ( 2a ) d'entrée avec retour à la source ( 20 ) de courant.

3. Agencement ( 10 ) d'optocoupleur suivant la revendication 2, dans lequel, du deuxième côté ( 1a" ) du premier trajet ( 1a ) d'entrée, le premier moyen ( T1 ) de commutation est relié à une première borne et une deuxième borne du premier moyen ( T1 ) de commutation est reliée au point ( M ).

4. Agencement ( 10 ) d'optocoupleur suivant la revendication 3, dans lequel, du premier côté ( 2a" ) du deuxième trajet ( 2a ) d'entrée, le deuxième moyen ( T2 ) de commutation est relié à une première borne et une deuxième borne du deuxième moyen ( T2 ) de commutation est reliée à la source ( 20 ) de courant.

5. Agencement ( 10 ) d'optocoupleur suivant l'une des revendications 1 à 4, dans lequel la première sortie ( 31 ) est reliée à une troisième borne du premier moyen ( T1 ) de commutation, la deuxième sortie ( 32 ) à une troisième borne du deuxième moyen ( T2 ) de commutation et la troisième sortie ( 33 ) à une troisième borne du moyen ( T3 ) de commutation de liaison.

6. Agencement ( 10 ) d'optocoupleur suivant l'une des revendications 1 à 5, dans lequel le circuit ( 30 ) de commande est conformé pour combiner logiquement la première entrée ( 11 ) du signal et la deuxième entrée ( 12 ) du signal, de manière à, pour un signal à la première entrée ( 11 ) du signal, activer le premier optocoupleur ( 1 ) et, pour un signal à la deuxième entrée ( 12 ) du signal, activer le deuxième optocoupleur ( 2 ) et, pour respectivement un signal à la première et à la deuxième entrées ( 11, 12 ) du signal, activer le premier et le deuxième optocoupleurs ( 1, 2 ) pour économiser du courant dans un montage série.

7. Module ( 50 ) d'entrée et/ou de sortie de la technique d'automatisation industrielle ayant au moins quatre canaux ( 51, 52, 53, 54 ), un premier canal ( 51 ) et un deuxième canal ( 52 ) étant conformés en ayant un premier agencement ( 10 ) d'optocoupleur suivant l'une des revendications 1 à 5, et un troisième canal ( 53 ) et un quatrième canal ( 54 ) étant conformés en ayant un deuxième agencement ( 10 ) d'optocoupleur suivant l'une des revendications 1 à 5.
